# EUROPEAN PATENT APPLICATION

(11) **EP 1 617 290 A1**
(43) Date of publication of application: **18.01.2006**
(21) Application number: 04405446.8
(22) Date of filing: 13.07.2004
(51) Int. Cl.: G03F 7/20, H01J 37/317

(54) **Apparatus and method for maskless lithography**

(71) Applicant: International Business Machines Corporation, Armonk, NY 10504 (US)
(72) Inventor: Allenspach, Rolf, CH-8314, Adilswil (CH); Marx, Gebhard, CH-8135, Langnau am Albis (CH); Riess, Walter, CH-8800 Thalwil (CH)
(74) Representative: Kretschmer, Thomas

(57) **Abstract**

The present invention is related to an apparatus and method for maskless lithography. The apparatus comprises an electron accelerating chamber (10) for accelerating electrons towards a support (12) on which a substrate (15) is mountable; a photon switching unit (20,21); and an electron emission layer (22) on the photon switching unit for outcoupling the electrons into the chamber. The photon switching unit with the electron emission layer is disposed opposite to the support and outcoupled electrons are directly acceleratable towards the support.

## Description

### TECHNICAL FIELD

The present invention is related to an apparatus and method for maskless lithography. More particularly, the invention relates to a maskless high-resolution programmable lithography technique.

### BACKGROUND OF THE INVENTION

The dramatic increase in performance and cost reduction in the electronics industry are attributable to innovations in the integrated circuit and packaging fabrication processes. The speed and performance of the chips, their associated packages, and, hence, the computer systems are dictated by the lithographic minimum printable size. Lithography, which replicates a pattern rapidly from chip to chip, wafer to wafer, or substrate to substrate, also determines the throughput and the cost of electronic systems. The lithography productivity has influence to and is a driver of the world economy.

Generally, a lithographic system includes exposure tool, mask, resist, and all of the processing steps to accomplish pattern transfer from a mask to a resist and then to devices.

From the late 1960s, when integrated circuits had linewidths of 5 µm, to 2004, when minimum linewidths have reached 0.90 nm in 1Gb DRAM circuits, optical lithography has been used ubiquitously for manufacturing. This dominance of optical lithography in production is the result of a worldwide effort to improve optical exposure tools and resists. Although lithography system costs (which are typically more than one third the costs of processing a wafer to completion) increase as minimum feature size on a semiconductor chip decreases, optical lithography remains attractive because of its high wafer throughput.

Electron-beam (e-beam) and X-ray lithographies have been considered as alternatives to optical lithography. However, wafer throughput with e-beam lithography is too slow for use in current semiconductor wafer production. Currently e-beam lithography is regarded as complementary to optical lithography. Optical lithography depends on e-beam lithography to generate the masks. Because of its intrinsic high resolution, e-beam lithography is at present the primary lithographic technique used in sub-quarter-micron device research.

X-ray lithography has been aimed at production since its inception. Efforts to displace optical lithography with X-ray lithography began in the 1960s, because of a presumption that the resolution of optical lithography was only suitable for dimensions greater than 1 µm. In addition to resolution limits, optical lithography had to solve the difficulties of lamp constraints and level-to-level overlay alignments.

Optical lithography requirements are most evident in a manufacturing environment as the wavelength of light for resist exposure is decreased to provide high-resolution DRAM minimum feature sizes.

US Patent 5,691,541 relates to a lithography system in which the mask or reticle, which usually carries the pattern to be printed onto a substrate, is replaced by a programmable array of binary (i.e. on/off) light valves or switches which can be programmed to replicate a portion of the pattern each time an illuminating light source is flashed. The pattern of light produced by the programmable array is imaged onto a lithographic substrate which is mounted on a scanning stage as is common in optical lithography. The stage motion and the pattern of light displayed by the programmable array are precisely synchronized with the flashing illumination system so that each flash accurately positions the image of the pattern on the substrate. This is achieved by advancing the pattern held in the programmable array by an amount which corresponds to the travel of the substrate stage each time the light source flashes. In this manner the image is built up of multiple flashes and an isolated defect in the array will only have a small effect on the printed pattern. The method includes projection lithographies using radiation other than optical or ultraviolet light. The programmable array of binary switches would be used to control extreme ultraviolet (EUV), x-ray, or electron, illumination systems, obviating the need for stable, defect free masks for projection EUV, x-ray, or electron, lithographies. However, the lithography system requires an optical projection system or illumination optics that is used in connection with a pulsed or strobed radiation source. As there are lines written by this system and the mirrors are not area-wide, always a gap remains. This does not allow to generate any desired geometry.

As optical lithography approaches its limits caused by photon wavelength and material properties, i.e. masks, lens materials, dielectric mirrors, photoresists, alternative techniques have to be developed.

From the above it follows that there is still a need in the art for a maskless lithography technique that overcomes the resolution limit and keeps the high throughput of a parallel imaging technique. A resolution limit of e-beam lithography should become feasible, without sacrificing the advantage of parallel illumination of optical lithography.

### SUMMARY AND ADVANTAGES OF THE INVENTION

In accordance with the present invention, there is provided a maskless lithography apparatus.

The apparatus comprises an electron accelerating chamber for accelerating electrons towards a support on which a substrate is mountable, a photon switching unit for generating photons or modulating photons, and an electron emission layer on the photon switching unit for outcoupling the electrons into the chamber. The photon switching unit with the electron emission layer is disposed opposite to the support and outcoupled electrons are directly acceleratable towards the support. Preferably, the photon switching unit with the electron emission layer is positioned within, i.e. inside, the electron accelerating chamber, but opposite to the support.

In more detail, the photon switching unit can comprise a photon emitting structure for generating photons and/or a photon modulating structure for modulating or influencing photons, e.g. by an external light source.

In accordance with another aspect of the present invention, there is provided a method for maskless lithography in an electron accelerating chamber in which electrons are accelerated towards a support on which a substrate is mountable. The method comprises the steps of providing a photon switching unit on which an electron emission layer is deposited, the photon switching unit with the deposited electron emission layer being disposed opposite to the support; outcoupling the electrons into the chamber via the electron emission layer; and accelerating the outcoupled electrons directly towards the substrate. The photon switching unit is provided for generating and/or modulating photons.

The presented apparatus and method allow the resolution limit to be overcome and to keep the high throughput of a parallel imaging technique. In general, the proposed apparatus comprises a 'photon switcher', that is the photon emitting or modulating structure. The photon switcher replaces the mask used in optical and also in e-beam lithography. It can comprise a two-dimensional array of individual pixels which serves two purposes: It is a modulator of light intensity and it is an emitter of photoelectrons. The electron emission layer emits the electrons into the chamber, where the electrons are transferred by an electron-optical lens element to a photoresist that is usually deposited on the substrate that is hold by the support. The electron-optical lens element provides several electrical fields between electrodes. In other words, the electron-optical lens element transfers the two-dimensional photoelectron pattern from the photon emitting structure to the photoresist under use of an electron beam. The photoresist is exposed by the incoming electrons as in e-beam lithography, however in a parallel fashion.

With the presented maskless approach, the ultimate resolution limit of e-beam lithography should become feasible, without sacrificing the advantage of parallel illumination of optical lithography.

Moreover, lithography becomes very flexible: Instead of a mask which can be patterned only once, a two-dimensional reprogrammable pixel array can be used. The individual pixel can comprise an LED with photocathode material on top and hence is switchable by an external voltage.

The lateral resolution can be on the nm-scale (limited by electron optics). The aproach is very fast, because imaging is done by parallel illumination of the photoresist rather than sequential as in standard e-beam lithography. It is projected to be 100 times faster than e-beam lithography.

The maskless approach is very flexible, because all the pixels are programmable. The dose performance for the development of the photoresist can be varied by the photon flux and the energy of illuminating electrons.

The photon switching unit can comprise pixel or array elements shaped such that aberrations are compensated. This would allow to compensate or counteract distortions and helps to minimize or avoid aberrations.

The photon emitting structure can be an organic light-emitting diode (OLED), light emitting diode (LED), liquid crystal display (LCD), or switchable transmission device. This allows to implement various technologies or to combine them.

Any geometrical form can be reproduced directly to the photoresist, as the maskless approach allows a direct exposure. Also three-dimensional structuring of the photoresist is possible by varying the photon generation in the photon emitting structure, e.g., by different voltages. The direct exposure avoids fraying.

It is advantageous when the photon emitting structure is programmable, because then each pixel is addressable individually and various structures can be reproduced to the photoresist. Moreover, the photon emitting structure is reusable may times for different structures, whilst a mask can be used for one structure only. This reduces production costs.

The mountable substrate on the support is fixed relative to the electron accelerating chamber and the electrons accelerated towards the support are controlled electron optically, which allows a precise reproduction of structures. Alternatively, the mountable substrate on the support can be moved micromechanically. This provides a possibility to move the substrate with the photoresist in order to support the creation of complicated structures.

In accordance with yet another aspect of the invention there is provided a maskless lithography device comprising multiple of the maskless lithography apparatus and one common support. The common support can be mounted centrally and the multiple apparatuses can be contemplated as multiple imaging columns. The electrons from the multiple apparatuses can be accelerated towards said one support. This allows to structure large areas or substrates on the support.

The number of outcoupled electrons defines structures on the substrate. That means, by varying the intensity of the light source and the exposure times, the structures on the substrate can be influenced.

### DESCRIPTION OF THE DRAWINGS

A preferred embodiment of the invention is described in detail below, by way of example only, with reference to the following schematic drawing.
- **Figure 1**: shows a schematic illustration of a lithography apparatus according to the invention with a photon emitting structure.
- **Figure 2**: shows a schematic illustration of a lithography apparatus according to the invention with a photon modulating structure.

The drawing is provided for illustrative purposes only.

### DETAILED DESCRIPTION OF AN EMBODIMENT

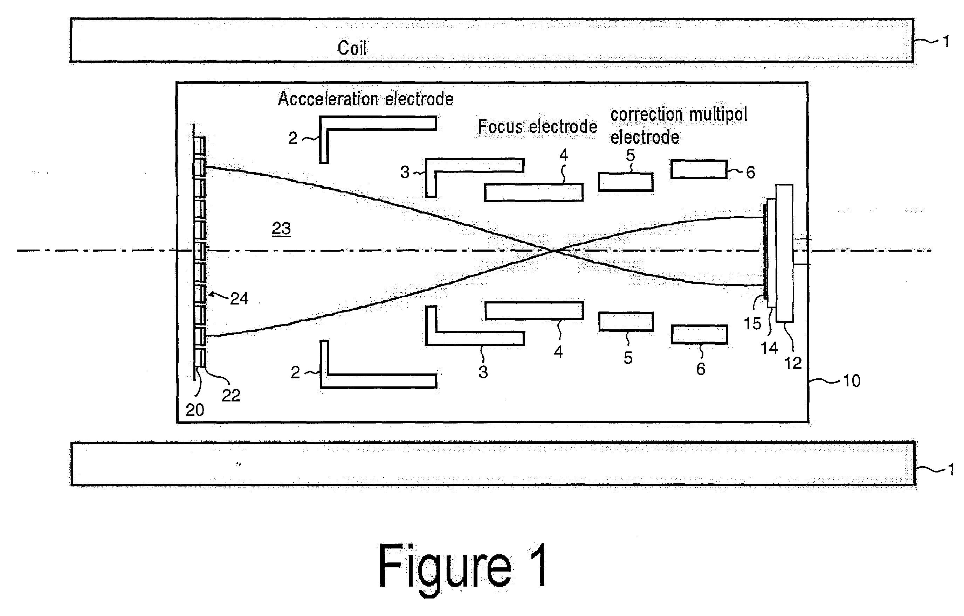

Figure 1 shows a schematic illustration of a maskless lithography apparatus with a photon switching unit that here comprises a photon emitting structure 20. The apparatus comprises an electron accelerating chamber 10 placed between coils 1. In the electron accelerating chamber 10 is provided the photon emitting structure 20 for generating electrons and an electron emission layer 22 on the photon emitting structure 20 for outcoupling the electrons into the chamber 10. In the chamber 10 are further provided electron-optical components such as an acceleration electrode 2, a first focusing electrode 3, a second focusing electrode 4, a correction electrode 5, and a multipol electrode 6. The electron-optical components 2 to 6 serve here as an electron-optical lens element. Opposite the photon emitting structure 20 with the electron emission layer 22 is a support 12 disposed on which a substrate 14 is mounted. A photoresist 15 is deposited onto the substrate 14. The photon emitting structure 20 with the electron emission layer 22 emits electrons 23 directly towards the support 12 as described below.

In more detail, the photon emitting structure 20 comprises multiple pixel or array elements 24, also referred to as photoelectron emitters 24, e.g. an OLED or LED. The electron emission layer 22 is also referred to as photocathode 22. The photoelectron emitter 20 emits the photons and the photocathode 22 converts photons into electrons. No external light source is needed in this arrangement.

In operation, the photon emitting structure 20 on which the electron emission layer 22 is deposited generates electrons and couples the electrons 23 out into the chamber 10 via the electron emission layer 22, i.e., the photocathode 22. Under use of the electron optical components 2 to 6 the outcoupled electrons 23 are directly accelerated towards the substrate 14 on the photoresist 15 for structuring the photoresist 15 respectively.

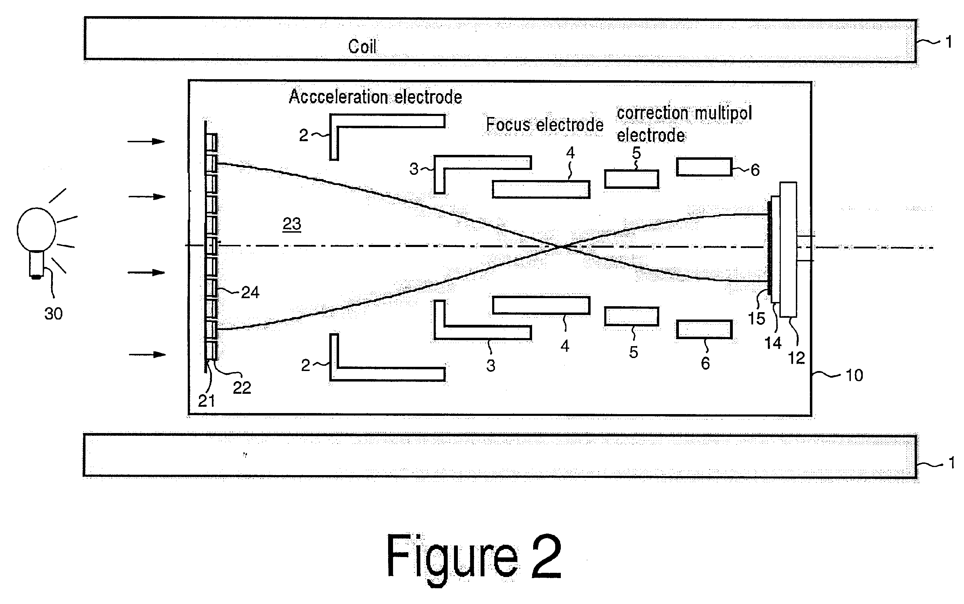

Figure 2 shows a schematic illustration of a lithography apparatus in which the photon switching unit comprises a photon modulating structure 21. The same reference numbers are used to denote the same parts. An external light source 30 is provided that illuminates the photon modulating structure 21 with photons, as indicated by the arrows in the figure. In this case, the photon switching structure serves as a modulator of the incoming light in front of the photocathode 22. The array of photoelectron emitters 24 with the photocathode can be addressed pixel wise and thereby a two-dimensional pattern is created. The electron optical components 2 to 6 demagnify the photocathode 22 to an image in the plane of the photoresist 15 or the substrate 14. Magnification is variable depending on the needs of lateral sizes. The electron dose for the development of the photoresist 15 can be varied by the photon flux and the energy of the illuminating electrons.

The photon switching unit 20 can be driven as a standard addressable matrix of e.g. LED, OLED or LCD displays. In the arrangement with the external light source 30, the individual pixels 24 are electrochrome switches. This electrochrome switch controls the transmission of the incident light. In the arrangement without the external light source 30, i.e. in Fig. 1, each individually addressable pixel is a switchable photodiode for example an active element, such as an OLED or LED. The photocathode 22 is evaporated directly onto the photodiode that is the photoelectron emitter. Photodiode display and photocathode should match in particular with respect to the wavelength. Typical material choices for inorganic matrix displays are for instance based on GaN and derivative compounds, for organic materials based on styryl and amine derivatives. A typical photocathode material is cesium potassium antimonide (CsK2Sb). For optimum resolution, electron optical distortions can be corrected by the shape of the photocathode or pixel elements For instance; an electron optical pin cushion distortion can be corrected by a barrel-shaped photocathode. The lateral demagnification of the photocathode structure is achieved by the electron optical elements 2 to 6. Additional electron optical correction and scanning elements can help to improve lateral resolution. Electron optical correction systems are known which might reduce or eliminate aberrations.

In a further embodiment and in particular with the embodiment described with reference to figure 2 deep UV lithography with a programmble LED array is applied. Again the photoresist 15 is directly exposed in an electron-optical way.

Any disclosed embodiment may be combined with one or several of the other embodiments shown and/or described. This is also possible for one or more features of the embodiments

## Claims

1. A maskless lithography apparatus comprising:
- an electron accelerating chamber (10) for accelerating electrons towards a support (12) on which a substrate (14) is mountable;
- a photon switching unit (20, 21); and
- an electron emission layer (22) on the photon switching unit (20, 21) for outcoupling the electrons into the chamber (10),
wherein the photon switching unit (20, 21) with the electron emission layer (22) is disposed opposite to the support (12) and outcoupled electrons are directly acceleratable towards the support (12).

2. The apparatus according to claim 1, wherein the a photon switching unit (20, 21) comprises one of a photon emitting structure (20) for generating photons, a photon modulating structure (21) for modulating photons, and a combination thereof.

3. The apparatus according to any of the preceding claims, wherein the photon switching unit (20, 21) comprises pixel elements (24) shaped such that aberrations are compensated.

4. The apparatus according to any of the preceding claims, wherein the photon switching unit (20, 21) is one of an OLED, LED, LCD, or switchable transmission device.

5. The apparatus according to any of the preceding claims, wherein the photon switching unit (20, 21) is programmable.

6. The apparatus according to any of the preceding claims, wherein the mountable substrate (14) on the support (12) is fixed relative to the electron accelerating chamber (10) and the electrons accelerated towards the support are controlled electron optically.

7. The apparatus according to any of the preceding claims, wherein the mountable substrate (14) on the support (12) is moved micromechanically.

8. A maskless lithography device comprising multiple of the maskless lithography apparatus according to any of the preceding claims and one support (12) for accelerating electrons from the apparatuses towards said one support (12).

9. A method for maskless lithography in an electron accelerating chamber (10) in which electrons are accelerated towards a support (12) on which a substrate (14) is mountable, the method comprising the steps of:
- providing a photon switching unit (20, 21) on which an electron emission layer (22) is deposited, the photon switching unit (20, 21) with the deposited electron emission layer (22) being disposed opposite to the support (12);
- outcoupling electrons into the chamber (10) via the electron emission layer (22); and
- accelerating the outcoupled electrons directly towards the substrate (14).

10. The method according to claim 9, wherein the number of outcoupled electrons defines structures on the substrate (14).
